# FASCICULE DE BREVET EUROPEEN

(11) **EP 3 134 929 B1**
(45) Date de publication et mention de la délivrance du brevet: **19.09.2018**
(21) Numéro de dépôt: 15723259.6
(22) Date de dépôt: 20.04.2015
(51) Int. Cl.: H01L 51/52

(54) **ELECTRODE SUPPORTEE TRANSPARENTE POUR OLED**
GESTÜTZTE TRANSPARENTE ELEKTRODE FÜR EINE OLED
TRANSPARENT, SUPPORTED ELECTRODE FOR OLED

(30) Priorité: 22.04.2014 FR 1453584
(43) Date de publication de la demande: 01.03.2017
(73) Titulaire: Saint-Gobain Glass France, 92400 Courbevoie (FR)
(72) Inventeur: LEE, Youngseong, Seoul (KR); HAN, Jinwoo, Seoul (KR)
(74) Mandataire: Saint-Gobain Recherche
(86) Numéro de dépôt international: PCT/FR2015/051069
(87) Numéro de publication internationale: WO 2015/162367

(56) Documents cités:
- WO-A1-2011/089343
- WO-A1-2013/117862
- WO-A1-2013/187735
- WO-A1-2014/013183
- US-A1- 2014 042 415
- US-A1- 2014 048 790

## Description

La présente invention concerne une électrode supportée destinée à être utilisée, de préférence en tant qu'anode, dans une diode électroluminescente organique.

Une diode électroluminescente organique (OLED, de l'anglais *Organic Light Emitting Diode*) est un dispositif opto-électronique comportant deux électrodes dont une au moins est transparente à la lumière visible, et un empilement de couches minces comportant au moins une couche émettrice de lumière (couche EL). Cette couche émettrice de lumière est prise en sandwich au moins entre, d'une part, une couche d'injection ou de transport d'électrons (EIL ou ETL) située entre la couche EL et la cathode et, d'autre part, une couche d'injection ou de transport de trous (HIL ou HTL) située entre la couche EL et l'anode.

Les OLED comportant un support d'électrode transparent et une électrode transparente en contact avec celui-ci sont classiquement appelées OLED à émission à travers le substrat ou OLED à émission vers le bas (*bottom emitting OLED*). L'électrode transparente est dans ce cas typiquement l'anode.

De façon analogue, les OLED comportant un support d'électrode opaque sont appelées OLED à émission vers le haut (*top emitting OLED*), l'émission se faisant alors à travers l'électrode transparente qui n'est pas en contact avec le support, généralement la cathode.

Au-delà d'un seuil de potentiel donné, la puissance lumineuse d'une OLED dépend directement de la différence de potentiel entre l'anode et la cathode. Pour fabriquer des OLED de grande taille présentant une puissance lumineuse homogène sur toute leur surface, il est nécessaire de limiter le plus possible la chute ohmique entre les arrivées de courant, généralement situées en bordure des OLED, et le centre de l'OLED. Une voie connue pour limiter cette chute ohmique est la réduction de la résistance par carré (R□ ou Rₛ, de l'anglais *sheet resistance*) des électrodes, typiquement par augmentation de leur épaisseur.

Une telle augmentation de l'épaisseur des électrodes pose toutefois d'importants problèmes lorsqu'il s'agit d'électrodes transparentes. En effet, les matériaux utilisés pour ces électrodes, par exemple l'ITO (Indium Tin Oxide), présentent une transmission lumineuse insuffisante et un coût prohibitif qui font que des épaisseurs supérieures à 500 nm sont très peu intéressantes. En pratique, les couches d'ITO ne dépassent pas environ 150 nm.

Il est bien connu de réduire ou surmonter ce problème de la conductivité insuffisante de l'ITO en doublant l'anode d'une grille métallique. Les grilles métalliques par exemple en cuivre ou, plus fréquemment, à triple couche Mo-Al-Mo ou Cr-Al-Cr (grilles MAM pour Métal-Aluminium-Métal) sont ainsi communément utilisées pour limiter la résistivité des anodes transparentes en ITO dans des dispositifs électro-optiques tels que des OLED (US 2006/0154550, US 2010/0079062, WO2005/053053).

La formation de telles grilles métalliques se fait généralement par dépôt de minces couches métalliques continues par pulvérisation cathodique, puis structuration (*patterning*) par photolithographie, comprenant une étape de gravure par un mélange approprié d'acides fort et faible, typiquement, H₃PO₄, HNO₃ et CH₃COOH, pour enlever le métal au niveau des ouvertures. Un mélange d'acides forts, tel que l'eau régale (HCl + HNO₃) généralement utilisée pour la gravure de l'ITO, peut aussi être utilisé. Toutefois, lorsque la grille métallique est sur l'ITO, il est difficile de contrôler la gravure et d'empêcher l'endommagement de la surface de l'ITO.

Lorsque la Demanderesse a mis en oeuvre de telles étapes de gravure à l'acide sur des substrats pour OLED portant des couches d'extraction internes (IEL, de l'anglais *Internal Extraction Layer*) à base d'émaux haut indice à forte teneur en bismuth, elle a eu la mauvaise surprise d'observer, dans le produit final, de forts courants de fuite et la formation progressive de points noirs (*pinholes*)*.* De tels courants de fuite, qui constituent un problème assez répandu dans le domaine des OLED, sont dus à des court-circuits aux endroits où l'anode est localement trop proche de la cathode. Ils résultent généralement d'irrégularités de surface qui présentent un relief non négligeable par rapport à l'épaisseur de l'empilement de couches organiques (ETL/EL/HTL).

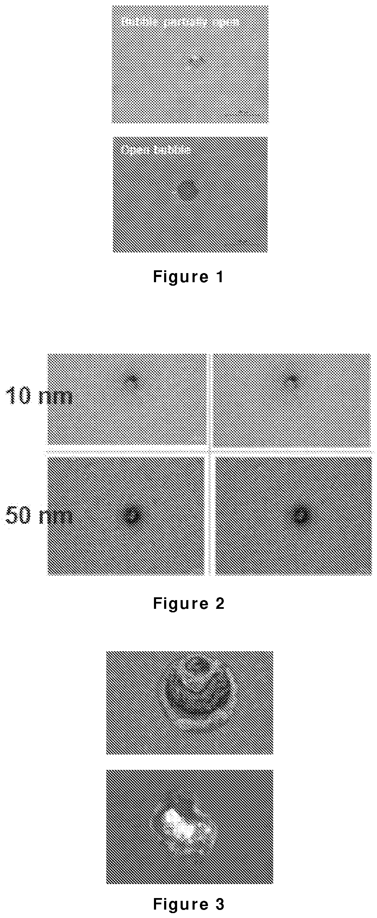

L'analyse par microscopie électronique des substrats comportant des IEL à base d'émaux haut indice à forte teneur en bismuth a montré qu'à l'origine de ces irrégularités de surface étaient de minuscules cratères, dus à la présence de bulles d'air figées en cours d'éclatement à la surface de la couche d'émail lors de la formation de celle-ci par fusion d'une fritte de verre (voir Figure 1). Ces minuscules cratères sont en nombre limité et d'une taille si petite que d'éventuels courants de fuite, générés dans les OLED fabriquées sur de tels substrats, devraient rester dans des limites acceptables. On a donc supposé que ces cratères étaient considérablement creusés et agrandis en cours de gravure du fait de la médiocre résistance aux acides des émaux à forte teneur en bismuth.

Ce qui était assez surprenant était le fait qu'on observait ce phénomène non seulement lorsqu'on gravait des couches métalliques directement en contact avec l'émail haut indice de la couche d'extraction interne (IEL) mais également lorsque la couche métallique était déposée au-dessus de la couche d'ITO (anode). Le même phénomène a aussi été observé, bien que plus rarement, lors de la gravure chimique de couches de TCO (sans grilles métalliques) et a été attribué à une protection insuffisante de la zone à fort relief (cratère) par le masque (*photoresist*)*.*

Le dépôt par pulvérisation cathodique de couches barrières, connues pour résister aux acides, telles que des couches de TiO₂, SnO₂, SiO₂, Si₃N₄ ou d'oxynitrure de silicium (SiON) en des épaisseurs allant de 20 à 150 µm, entre l'IEL et l'anode n'a pas non plus permis de réduire de manière significative le phénomène des courants de fuite et points noirs dans les OLED fabriquées à partir de ces substrats.

La figure 3 montre les défauts de surface observés après gravure acide d'une couche métallique déposée par pulvérisation cathodique magnétron sur une anode en ITO (épaisseur d'environ 150 µm), elle-même déposée par pulvérisation cathodique magnétron sur une couche barrière en SiON d'une épaisseur de 100 nm.

US2014/0048790 décrit un dispositif OLED comprenant une couche diffusante formée d'un émail haut indice et un empilement de deux couches barrières, par example TiO₂/TiZrₓO_{y}, entre la couche diffusante et la première électrode.

US2014/0042415 décrit un dispositif OLED comprenant une couche diffusante haut indice recouverte d'une couche barrière monocouche pouvant être déposée par ALD.

WO2013/187735 décrit un dispositif OLED comprenant une couche diffusante formée d'un émail haut indice recouverte d'une couche barrière comprenant SiO2 ou Si3N4 ou une alternance de ces deux couches.

La présente invention est basée sur la découverte que les petits défauts (cratères, Figure 1) à la surface de couches d'émail à forte teneur en bismuth peuvent être protégés efficacement contre les dégâts causés par la gravure acide, au moyen d'une très mince couche de certains oxydes métalliques, à condition que cette couche soit formée par dépôt de couches atomiques (ALD, de l'anglais *atomique layer déposition*).

Cette couche mince de protection doit être située entre la couche diffusante (IEL) en émail, d'une part, et la grille métallique de l'anode, d'autre part. Elle sera formée sous l'anode constituée du TCO et de la grille métallique, de préférence directement sur la couche d'émail.

La présente invention a donc pour objet une électrode transparente telle que décrite dans la revendication 1.

Elle a également pour objet un procédé de fabrication d'une telle électrode transparente, comprenant le dépôt de la couche barrière par ALD, tel que décrit dans la revendication 7, et une OLED (organic light emitting diode) contenant une telle électrode transparente, telle que décrite dans la revendication 6.

D'autres aspects de la présente invention sont décrits dans les revendications dépendantes.

On remarquera que l'électrode transparente telle que définie ci-dessus ne comporte pas encore forcément une grille métallique. La Demanderesse envisage en effet la mise sur le marché d'une électrode supportée telle que définie ci-dessus dont l'anode en TCO sera structurée ultérieurement par gravure et pourvue d'une grille métallique par le fabricant d'OLED. Lors de l'étape de gravure acide du TCO et lors de la formation de la grille métallique impliquant également une étape de gravure acide, la couche de protection déposée par ALD protégera efficacement l'émail riche en bismuth contre l'érosion par les acides et empêchera la formation de points noirs dans l'OLED finale.

La présente invention concerne bien entendu également une électrode supportée transparente complète qui comporte, en plus des couches (i) à (iv) ci-dessus, une grille métallique destinée à augmenter la conductivité de l'électrode. Cette grille métallique peut être située sous ou sur la couche de TCO et doit être directement en contact électrique avec celle-ci.

Dans un premier mode de réalisation l'électrode transparente de la présente invention, comprend donc, dans l'ordre,
∘ un substrat transparent en verre minéral,
∘ une couche diffusante formée d'un émail haut indice contenant au moins 30 % en poids de Bi₂O₃,
∘ une couche barrière comportant plusieurs couches d'Al2O3 en alternance avec des couches d'oxydes à plus haut indice (n>2) choisis parmi TiO₂, ZrO2 et HfO2 déposée par ALD,
∘ une couche d'un oxyde conducteur transparent (TCO),
∘ une grille métallique directement en contact avec la couche de TCO.

Dans un deuxième mode de réalisation l'ordre des deux dernières couches est inversé par rapport au premier mode de réalisation et l'électrode transparente de la présente invention, comprend, successivement
∘ un substrat transparent en verre minéral,
∘ une couche diffusante formée d'un émail haut indice contenant au moins 30 % en poids de Bi₂O₃,
∘ une couche barrière comportant plusieurs couches d'Al2O3 en alternance avec des couches d'oxydes à plus haut indice (n>2) choisis parmi TiO₂, ZrO2 et HfO2 déposée par ALD,
∘ une grille métallique directement en contact avec la couche de TCO.
∘ une couche d'un oxyde conducteur transparent (TCO).

Le substrat en verre minéral peut avoir n'importe quelle épaisseur compatible avec l'utilisation envisagée. On utilisera classiquement des feuilles de verre ayant une épaisseur comprise entre 0,3 et 5 mm, en particulier entre 0,7 et 3 mm. Toutefois, l'utilisation de feuilles de verre ultramince ayant des épaisseurs plus faibles, typiquement comprises entre 50 nm et 300 nm est également envisageable, à condition de résoudre les problèmes mécaniques qu'implique la formation d'une couche d'émail, en l'occurrence l'émail à haut indice, sur des verres aussi minces.

Le substrat est surmonté d'une couche diffusante formée d'un émail haut indice contenant au moins 30 % en poids de Bi₂O₃. On entend par émail « haut indice » ici un émail ayant un indice de réfraction (à λ = 550 nm) au moins égal à 1,7, de préférence compris entre 1,8 et 2,2.

La couche diffusante (ii) joue le rôle de couche interne d'extraction de la lumière (en anglais *Internal Extraction Layer,* IEL).

Il est connu depuis longtemps dans le domaine des OLED, qu'une petite fraction seulement de la lumière produite par la couche électroluminescente est émise vers l'extérieur, à travers l'anode transparente et le substrat en verre. En effet, comme l'indice optique du substrat en verre (nᵥₑᵣᵣₑ = 1,5) est inférieur à celui des couches organiques (n = 1,7 - 1,8) et de l'anode transparente (n = 1,9 à 2,1), la majeure fraction (environ 50 %) de la lumière se trouve piégée dans ces couches à haut indice comme dans un guide d'onde et est absorbée après un certain nombre de réflexions. Un phénomène analogue se produit à l'interface entre le verre du substrat (nᵥₑᵣᵣₑ = 1,5) et l'air (nₐᵢᵣ = 1,0) et piège environ 20 % de la lumière émise par la couche électroluminescente.

Il est connu de réduire ce phénomène de piégeage de la lumière (réflexion totale interne) dans les couches à haut indice d'une OLED en insérant, entre le substrat en verre et l'anode transparente, un moyen d'extraction de la lumière, formé par exemple par un émail à haut indice contenant des particules diffusantes ou par une interface suffisamment rugueuse pour être diffusante, planarisée par une couche d'émail haut indice.

L'expression « couche diffusante » englobe donc dans la présente invention
- une couche d'émail à haut indice de réfraction dans lequel sont dispersés des éléments diffusants, et
- une interface rugueuse entre deux milieux d'indices différents, typiquement la surface du verre présentant un certain relief de rugosité couvert par une couche d'émail haut indice.

Dans un mode de réalisation, l'émail haut indice formant la couche diffusante contient donc des éléments diffusants la lumière, dispersés dans l'épaisseur de la couche. Ces éléments diffusants ont un indice de réfraction plus élevé ou plus faible que l'indice de l'émail. Pour diffuser la lumière, ces éléments doivent avoir des dimensions non négligeables par rapport à la longueur d'onde de la lumière à extraire, par exemple une taille comprise entre 0,1 et 5 µm, de préférence entre 0,4 et 3 µm. Les éléments diffusants peuvent être par exemple des particules solides ajoutées à la fritte de verre avant fusion, des cristaux formés lors de la fusion de la fritte ou encore des bulles d'air formées pendant l'étape de fusion de la fritte et piégées dans l'émail solidifié.

Dans un autre mode de réalisation, la rugosité de l'interface entre l'émail haut indice (n ≥ 1,7) et le milieu d'indice inférieur sous-jacent (substrat en verre ou couche de bas indice formée à la surface du verre) est à l'origine du phénomène de diffusion. L'interface entre l'émail haut indice et le milieu d'indice inférieur sous-jacent (substrat) présente de préférence un profil de rugosité avec un écart moyen arithmétique Rₐ au moins égal à 0,1 µm, de préférence compris entre 0,2 et 5 µm, en particulier entre 0,3 et 3 µm.

Dans l'éventualité où une couche intermédiaire à bas indice de réfraction (n<1,6) est prévue entre le substrat en verre et l'émail, par exemple une couche barrière protégeant l'émail haut indice contre la diffusion d'ions alcalins provenant du substrat, c'est l'interface entre cette couche bas indice et l'émail haut indice qui constitue le relief présentant ce profil de rugosité.

Bien entendu il est possible de combiner ces deux modes de réalisation de la couche diffusante par exemple en introduisant des éléments diffusants, tels que des bulles d'air, dans un émail haut indice déposé sur une surface de verre rugueuse, le point essentiel étant que la face supérieure de l'IEL coïncide avec la face supérieure de l'émail haut indice.

Il existe un certain nombre de compositions de verre permettant d'obtenir des émaux à haut indice. La présente invention est particulièrement focalisée sur des émaux à teneur élevée en bismuth qui présentent une assez faible résistance chimique aux acides, à l'origine des courants de fuite et points noirs comme expliqué en introduction.

Les émaux haut indice de la présente invention contiennent au moins 30 % en poids, de préférence au moins 50 % en poids et en particulier au moins 65 % en poids de Bi₂O₃. Ces émaux sont connus et décrits par exemple dans la demande internationale WO2013/187736 et WO2014/128421 et FR3002533.

L'émail à haut indice contient par exemple de 55 à 84 % en poids de Bi₂O₃, jusqu'à environ 20 % en poids de BaO, de 5 à 20 % en poids de ZnO, de 1 à 7% en poids d'Al₂O₃, de 5 à 15 % en poids de SiO₂, de 5 à 20 % en poids de B₂O₃ et jusqu'à 0,3 % en poids de CeO₂.

Dans la présente invention une couche d'oxyde métallique diélectrique (couche (iii)) est déposée par ALD (*atomic layer deposition*) sur l'émail haut indice décrit ci-avant. Ce dépôt se fait de préférence directement sur la surface de l'émail haut indice. Le dépôt de couches atomiques est une méthode bien connue permettant la formation de couches extrêmement minces, uniformes et étanches.

Un précurseur gazeux, mis en contact avec une surface, s'y adsorbe sous forme de monocouche par chimisorption ou physisorption. Après purge du gaz précurseur, un deuxième composant gazeux, capable de réagir avec le précurseur adsorbé, est admis dans la chambre. Après réaction, la chambre est de nouveau purgée et le cycle « adsorption - purge - réaction - purge » peut recommencer.

Le tableau ci-après montre quelques exemples de précurseurs et réactifs permettant la formation des oxydes métalliques diélectriques de la couche (iii) de la présente invention

| Oxyde métallique diélectrique | Précurseur gazeux | Réactif gazeux |
|---|---|---|
| Al₂O₃ | Al(CH₃)₃ | H₂O |
| ZrO₂ | Tetrakis(éthylméthylamino)zirconium Zr[(N(CH₃) (C₂H₅)]₄ | H₂O |
| TiO₂ | Tétrakis(diméthylamino)titane Ti[N(CH₃)₂]₄ | H₂O |

On pourra également se référer à des revues bibliographiques telles que l'article de Markku Leskelä et al. « Atomic layer deposition (ALD) : from precursors to thin film structures », Thin solid film, 409 (2002) 138 - 146 et l'article de Steven M. George intitulé "Atomic Layer Déposition : An Overview, Chem. Rev. 2010, 110, 111 - 131, qui donnent de très nombreux exemples de systèmes précurseurs/réactifs.

La couche barrière est une couche complexe formée de plusieurs sous-couches successives de différents oxydes métalliques, toutes déposées par ALD.

Selon présente invention, la couche barrière ALD comporte plusieurs couches d'Al₂O₃ (n ≈ 1,7) en alternance avec des couches d'oxyde à plus haut indice (n>2) choisis parmi TiO₂, ZrO₂, et HfO₂. L'oxyde d'aluminium présente en effet l'avantage d'être très résistant aux acides forts utilisés pour la gravure des métaux, tels que l'eau régale (*aqua regia*)*.* Son indice de réfraction relativement faible par rapport à celui des couches organiques de l'OLED et la perte optique qui en résulte interdisent toutefois l'utilisation de mono-couches d'Al₂O₃ épaisses. En alternant des couches d'Al₂O₃ avec des couches de TiO₂, ZrO₂ ou HfO₂ il est possible d'augmenter l'épaisseur globale de la couche ALD sans augmenter les pertes optiques.

L'épaisseur globale de la couche ALD est de préférence comprise entre 5 et 200 nm, en particulier entre 10 et 100 nm. Lorsqu'il s'agit d'une couche complexe comportant une alternance de sous-couches d'Al₂O₃ et de sous-couches d'indice plus élevé telles que TiO₂, ZrO₂ et HfO₂, l'épaisseur de chacune des sous-couches est de préférence comprise entre 1 et 50 nm, en particulier entre 2 et 10 nm. Le nombre de sous-couches peut être compris entre 2 et 200, de préférence entre 3 et 100, en particulier entre 5 et 10. Le nombre de couches Al₂O₃ est de préférence compris entre 2 et 5, il est en particulier égal à 2 ou 3.

Dans un mode de réalisation préféré les deux couches externes de l'empilement de sous-couches sont des couches d'Al₂O₃ qui assurent un bon contact avec les matériaux adjacents.

Au microscopique électronique une couche d'un oxyde métallique diélectrique déposée par ALD peut être aisément différenciée d'une couche déposée par pulvérisation cathodique. Elle se distingue, de manière connue, par une épaisseur extrêmement uniforme, une continuité parfaite, même pour de faibles épaisseurs, et par une grande conformité au relief du substrat sous-jacent, même sur des surfaces à relief très prononcé.

Au-dessus de la couche formée par ALD se trouve l'électrode transparente proprement dite. Cette électrode se compose d'une couche d'un TCO, généralement déposée par pulvérisation cathodique, et d'une grille métallique, ces deux structures étant en contact l'une avec l'autre. Comme déjà expliqué ci-dessus, la grille métallique peut être sous la couche de TCO - entre la couche de TCO et la couche ALD - ou sur la couche de TCO.

La présente invention n'est pas particulièrement limitée à certaines structures ou dimensions de grilles. La nature du métal formant la grille n'est pas non plus déterminant. Il est toutefois essentiel que la grille soit formée selon un procédé comprenant une étape de gravure acide d'une couche métallique, typiquement à travers un masque. Comme expliqué en introduction, la Demanderesse a en effet constaté que c'est cette étape de gravure à l'acide qui semble être à l'origine des défauts observés dans le produit fini (courants de fuite, points noirs). Des procédés de formation de telles grilles par photolithographie et gravure acide sont connus.

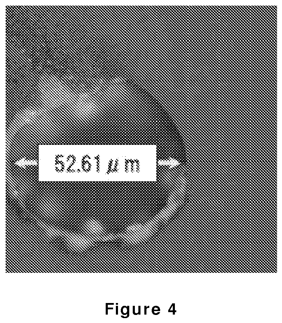

La Demanderesse a observé, rarement, des points noirs donnant lieu à des courants de fuite, même lorsque l'OLED ne comportait aucune grille métallique. Un examen au microscope électronique de l'aspect de ces points noirs a montré qu'ils correspondaient aussi de toute évidence à des cratères creusés (voir Figure 4). La Demanderesse suppose que l'attaque chimique de ces défauts de surface se produit au moment de la gravure acide de la couche de TCO dans les zones où le relief de surface est trop prononcé pour être protégé convenablement par une couche de photoresist de faible épaisseur (1 à 2 µm). L'utilisation d'une couche barrière déposée par ALD entre l'émail de la couche IEL et le TCO arrive efficacement à empêcher ce type de points noirs.

La couche TCO est déposée sur l'émail haut indice protégé par la couche d'oxyde métallique diélectrique, par des procédés de dépôt usuels tels que la pulvérisation cathodique magnétron, les procédés sol-gel ou la pyrolyse (CVD).

On peut en principe utiliser pour cette couche d'électrode n'importe quel oxyde conducteur transparent ou translucide présentant un indice de réfraction suffisamment élevé, proche de l'indice moyen de l'empilement organique d'une OLED (HTL/EL/ITL). On peut citer à titre d'exemple de tels matériaux les oxydes conducteurs transparents tels que l'oxyde de zinc dopé à l'aluminium (AZO), l'oxyde d'étain dopé à l'indium (ITO), l'oxyde d'étain et de zinc (SnZnO) ou le dioxyde d'étain (SnO₂). Ces matériaux ont avantageusement un coefficient d'absorption très inférieur à celui des matériaux organiques formant l'empilement HTL/EL/ITL, de préférence un coefficient d'absorption inférieur à 0,005, en particulier inférieur à 0,0005. On utilisera de préférence de l'ITO. L'épaisseur de la couche d'oxyde conducteur transparent est typiquement comprise entre 50 et 200 nm.

Le procédé de fabrication d'une électrode supportée transparente pour OLED de la présente invention, comprend au moins les trois étapes successives suivantes
(a) la mise à disposition d'un substrat transparent portant, sur une de ses faces, une couche diffusante formée d'un émail haut indice contenant au moins 30 % en poids de Bi₂O₃,
(b) la formation par ALD, sur l'émail haut indice et directement en contact avec celui-ci, d'une couche comportant plusieurs couches d'Al₂O₃ en alternance avec des couches d'oxydes à plus haut indice (n>2) choisis parmi TiO₂, ZrO₂ et HfO₂,
(c) formation d'une couche de TCO sur la couche d'oxyde métallique diélectrique (b).

Lorsque le procédé selon l'invention comporte uniquement ces trois étapes, il aboutit à un produit intermédiaire (substrat-émail haut indice-couche ALD-couche TCO) destiné à recevoir ultérieurement la grille métallique.

Le procédé de fabrication d'une électrode transparente supportée complète selon l'invention comprendra bien entendu en outre une étape additionnelle (étape (d)) de formation d'une grille métallique directement en contact avec la couche d'oxyde conducteur transparent, cette étape (d) comportant au moins une étape de gravure à l'acide.

Cette étape de gravure à l'acide est mise en oeuvre sur une couche métallique continue couverte par un masque créé par exemple par sérigraphie ou photolithographie, l'acide servant à éliminer le métal dans certaines zones non couvertes par le masque, de manière à former les ouvertures de la grille.

L'épaisseur de la couche métallique, et donc la hauteur de la grille résultante, est de l'ordre de plusieurs centaines de nanomètres, typiquement de 0,5 à 1 µm, de préférence de 0,6 à 0,8 µm. La largeur des brins de la grille est généralement comprise entre 10 µm et environ 100 µm.

Dans un premier mode de réalisation du procédé selon l'invention, l'étape (d) est mise en oeuvre après l'étape (c) de manière à ce que la grille métallique soit en contact avec la couche de TCO mais non pas avec la couche barrière d'oxyde métallique.

Dans un deuxième mode de réalisation, l'étape (d) est mise en oeuvre après l'étape (b) et avant l'étape (c) de manière à ce que la grille métallique soit en contact à la fois avec la couche barrière d'oxyde métallique diélectrique et avec la couche de TCO.

La grille métallique constitue toujours un relief, car même lorsque la couche de TCO est déposée sur la grille métallique, comme dans ce deuxième mode de réalisation, il est évident, compte tenu des épaisseurs respectives de ces deux structures (0,05 à 0,2 µm pour la couche de TCO, 0,5 à 1 µm pour la grille), que la couche de TCO n'arrive pas à recouvrir et aplanir ce relief.

Dans tous les cas, la grille métallique doit donc être couverte d'une couche de passivation qui laisse bien entendu libre les ouvertures gravées par l'acide, qui constituent les zones éclairées de l'OLED finale. Le recouvrement des grilles d'électrode par une couche de passivation fait également partie des connaissances générales de l'homme du métier spécialisé dans la fabrication d'OLED.

Avant application des couches émettrices de lumière, le substrat pour OLED est avantageusement couvert de manière connue d'un matériau organique d'injection de trous tel que le PEDOT/PSS (polyéthylènedioxythiophène/poly(styrène sulfonate)) qui permet de planariser le relief du substrat décrit ci-dessus.

### Exemple, non conforme à la présente invention, illustrant le principe de la présente invention

On dépose sur une feuille de verre minéral d'une épaisseur de 0,7 mm une couche d'un émail haut indice par fusion d'une fritte de verre ayant la composition suivante (% en poids) : 65 % de Bi₂O₃, 12,6 % de ZnO, 12,9 % de SiO₂, 2,6 % de Al₂O₃, et 6,9 % de B₂O₃.

Une pâte de fritte de verre dans un milieu organique (75 % en poids de fritte, 22 % en poids de solvant organique volatil et 3 % d'éthylcellulose) est déposée par sérigraphie, séchée (environ 20 minutes à 130 °C), l'éthylcellulose est éliminée par un traitement thermique de 20 minutes à 430 °C, puis la fritte est portée à 540 °C pendant 10 minutes. Cette fusion est mise en oeuvre à pression atmosphérique ce qui se traduit par la formation de nombreuses bulles d'air dans la couche d'émail. La couche d'émail haut indice ainsi formée présente des défauts de surface dus à des bulles d'air figées en cours d'éclatement.

La figure 1 montre deux clichés de microscopie électronique à balayage (MEB) d'une bulle partiellement ouverte (*bubble partially open*) et totalement overte (*open bubble*) à la surface de l'émail.

On dépose ensuite sur deux échantillons de substrat portant l'émail haut indice une couche d'Al₂O₃ d'une épaisseur de 10 nm et 50 nm respectivement. La figure 2 montre, à gauche, des clichés de MEB de deux défauts de surface (bulles d'air figées en cours d'éclatement) repérés sur ces émaux protégés par la couche ALD.

On soumet ensuite ces mêmes substrats à une étape de gravure acide avec une solution d'acide phosphorique à pH < 1, 100 secondes à une température de 45 °C.

La figure 2 montre, à droite, les clichés MEB des mêmes défauts de surface après l'étape de gravure. On constate que leur aspect est strictement identique à celui avant gravure.

A titre comparatif, la figure 3 montre deux clichés MEB de défauts de surface observés après gravure acide (une solution d'acide phosphorique à pH < 1, 100 secondes à une température de 45 °C) d'une couche métallique déposée sur une anode en ITO (épaisseur d'environ 150 µm), elle-même déposée sur une couche barrière en SiON d'une épaisseur de 100 nm sur un émail de la composition indiquée ci-dessus, l'anode en ITO et la couche barrière étant déposées par pulvérisation cathodique magnétron.

Ces défauts (même agrandissement que la figure 2) ont une dimension considérablement plus importante que les bulles d'air d'origine.

## Revendications

1. Electrode transparente supportée pour OLED, comprenant, successivement
(i) un substrat transparent en verre minéral,
(ii) une couche diffusante formée d'un émail haut indice ayant un indice de réfraction (à λ = 550 nm) au moins égal à 1,7 et contenant au moins 30 % en poids de Bi₂O₃,
(iii) une couche barrière d'au moins un oxyde métallique diélectrique choisi dans le groupe constitué de Al₂O₃, TiO₂, ZrO₂ et HfO₂ déposée par dépôt de couche atomique (ALD),
(iv) une couche d'un oxyde conducteur transparent (TCO) **caractérisée par le fait que** la couche barrière déposée par ALD comporte plusieurs couches d'Al₂O₃ en alternance avec des couches d'oxydes à plus haut indice (n>2) choisis parmi TiO₂, ZrO₂, et HfO₂.

2. Electrode selon la revendication 1, comprenant en outre une grille métallique sous ou sur la couche de TCO et directement en contact avec celle-ci.

3. Electrode selon l'une quelconque des revendications précédentes, dans laquelle la couche barrière déposée par ALD a une épaisseur comprise entre 5 et 200 nm, de préférence entre 10 et 100 nm.

4. Electrode selon l'une quelconque des revendications précédentes, dans laquelle l'émail haut indice formant la couche diffusante contient des éléments diffusants la lumière, dispersés dans l'épaisseur de la couche.

5. Electrode selon l'une quelconque des revendications précédentes, dans laquelle l'interface entre l'émail haut indice et le milieu d'indice inférieur sous-jacent présente un profil de rugosité avec un écart moyen arithmétique Rₐ au moins égal à 0,1 µm, de préférence compris entre 0,2 et 5 µm, en particulier entre 0,3 et 3 µm.

6. OLED comportant une électrode selon l'une quelconque des revendications précédentes.

7. Procédé de fabrication d'une électrode supportée transparente pour OLED selon l'une quelconque des revendications précédentes, comprenant les étapes successives suivantes
(a) mise à disposition d'un substrat transparent portant, sur une de ses faces, une couche diffusante formée d'un émail haut indice contenant au moins 30 % en poids de Bi₂O₃,
(b) formation, par dépôt de couche atomique (ALD), d'une couche barrière comportant plusieurs couches d'Al₂O₃ en alternance avec des couches d'oxyde à plus haut indice (n>2) choisis parmi TiO₂, ZrO₂ et HfO₂ sur l'émail haut indice et directement en contact avec celui-ci,
(c) formation d'une couche d'un oxyde conducteur transparent (TCO) au-dessus de la couche d'oxyde métallique diélectrique (b).

8. Procédé selon la revendication 7, comprenant en outre une étape (d) de formation d'une grille métallique directement en contact avec la couche d'oxyde conducteur transparent, cette étape (d) comportant au moins une étape de gravure à l'acide.

9. Procédé selon la revendication 8, dans lequel l'étape (d) est mise en oeuvre après l'étape (b) et avant l'étape (c) de manière à ce que la grille métallique soit en contact à la fois avec la couche barrière d'oxyde métallique diélectrique et avec la couche de TCO.

10. Procédé selon la revendication 8, dans lequel l'étape (d) est mise en oeuvre après l'étape (c) de manière à ce que la grille métallique soit en contact avec la couche de TCO mais non pas avec la couche barrière d'oxyde métallique.

## Patentansprüche

1. Gestützte transparente Elektrode für OLED, die nacheinander Folgendes umfasst
(i) ein transparentes Substrat aus Mineralglas,
(ii) eine diffundierende Schicht, die aus einem Email mit hohem Index gebildet ist, das einen Brechungsindex (bei λ= 550 nm) von mindestens 1,7 hat und mindestens 30 Gew.-% Bi₂O₃ enthält,
(iii) eine Sperrschicht aus mindestens einem dielektrischen Metalloxid, ausgewählt aus der Gruppe, die aus Al₂O₃, TiO₂, ZrO₂ und HfO₂ besteht, die durch Atomschichtabscheidung (ALD) abgeschieden wird,
(iv) eine Schicht aus einem transparenten leitfähigen Oxid (TCO),
**dadurch gekennzeichnet, dass** die Sperrschicht, die durch ALD abgeschieden wird, mehrere Schichten aus Al₂O₃ im Wechsel mit Oxidschichten mit höherem Index (n>2), ausgewählt aus TiO₂, ZrO₂ und HfO₂, umfasst.

2. Elektrode nach Anspruch 1, die außerdem ein Metallgitter unter oder auf der TCO-Schicht und direkt in Berührung mit dieser umfasst.

3. Elektrode nach einem der vorhergehenden Ansprüche, bei der die Sperrschicht, die durch ALD abgeschieden wird, eine Stärke zwischen 5 und 200 nm, bevorzugt zwischen 10 und 100 nm, aufweist.

4. Elektrode nach einem der vorhergehenden Ansprüche, wobei das Email mit hohem Index, der die diffundierende Schicht bildet, Licht diffundierende Elemente enthält, die in der Stärke der Schicht verstreut sind.

5. Elektrode nach einem der vorhergehenden Ansprüche, bei der die Schnittfläche zwischen dem Email mit hohem Index und dem darunter liegenden Milieu mit niedrigerem Index bevorzugt ein Rauheitsprofil mit einer mittleren arithmetischen Abweichung Rₐ von mindestens 0,1 µm, bevorzugt zwischen 0,2 und 5 µm, insbesondere zwischen 0,3 und 3 µm aufweist.

6. OLED, die eine Elektrode nach einem der vorhergehenden Ansprüche umfasst.

7. Herstellungsverfahren einer gestützten transparenten Elektrode für OLED nach einem der vorhergehenden Ansprüche, das die folgenden aufeinanderfolgenden Schritte umfasst
(a) Bereitstellen eines transparenten Substrats, das auf einer seiner Flächen eine diffundierende Schicht trägt, die aus einem Email mit hohem Index gebildet ist, das mindestens 30 Gew.-% Bi₂O₃ enthält,
(b) Bilden durch Atomschichtabscheidung (ALD) einer Sperrschicht, die mehrere Schichten aus Al₂O₃ im Wechsel mit Oxidschichten mit höherem Index (n>2), die aus TiO₂, ZrO₂ und HfO₂ ausgewählt sind, auf dem Email mit hohem Index und direkt in Berührung mit diesem umfasst,
(c) Bilden einer transparenten leitfähigen Oxidschicht (TCO) über der dielektrischen Metalloxidschicht (b).

8. Verfahren nach Anspruch 7, das außerdem einen Schritt (d) des Bildens eines Metallgitters, das direkt mit der transparenten leitfähigen Oxidschicht in Berührung ist, umfasst, wobei dieser Schritt (d) mindestens einen Säureätzschritt umfasst.

9. Verfahren nach Anspruch 8, wobei der Schritt (d) nach dem Schritt (b) und vor dem Schritt (c) derart umgesetzt wird, dass das Metallgitter sowohl mit der Sperrschicht aus dielektrischem Metalloxid als auch mit der TCO-Schicht in Berührung ist.

10. Verfahren nach Anspruch 8, wobei der Schritt (d) nach dem Schritt (c) derart umgesetzt wird, dass das Metallgitter mit der TCO-Schicht in Berührung ist, nicht aber mit der Metalloxidsperrschicht.

## Claims

1. Supported transparent electrode for an OLED, comprising, in succession:
(i) a transparent substrate made of mineral glass;
(ii) a scattering layer made of a high-index enamel having a refractive index of at least 1.7 (at λ = 550 nm) and containing at least 30% by weight Bi₂O₃;
(iii) a barrier layer of at least one dielectric metal oxide selected from the group consisting of Al₂O₃, TiO₂, ZrO₂ and HfO₂, deposited by atomic layer deposition (ALD); and
(iv) a layer of a transparent conductive oxide (TCO),
**characterized in that** the barrier layer deposited by ALD comprises a plurality of Al₂O₃ layers in alternation with layers of oxides of higher indices (n>2) selected from TiO₂, ZrO₂, and HfO₂.

2. Electrode according to Claim 1, further comprising a metal grid under or over the TCO layer and making direct contact therewith.

3. Electrode according to any one of the preceding claims, wherein the thickness of the barrier layer deposited by ALD is comprised between 5 and 200 nm, preferably between 10 and 100 nm.

4. Electrode according to any one of the preceding claims, wherein the high-index enamel forming the scattering layer contains elements that scatter light, dispersed throughout the thickness of the layer.

5. Electrode according to any one of the preceding claims, wherein the interface between the high-index enamel and the underlying medium of lower index has a roughness profile with an arithmetic mean deviation Rₐ at least equal to 0.1 µm, preferably comprised between 0.2 and 5 µm and in particular between 0.3 and 3 µm.

6. OLED comprising an electrode according to any one of the preceding claims.

7. Process for manufacturing a supported transparent electrode for an OLED according to any one of the preceding claims, comprising the following successive steps:
(a) providing a transparent substrate bearing, on one of its faces, a scattering layer formed from a high-index enamel containing at least 30% by weight Bi₂O₃;
(b) forming by atomic layer deposition (ALD), on the high index enamel and in direct contact therewith, a barrier layer comprising a plurality of Al₂O₃ layers in alternation with layers of oxides of higher indices (n>2) selected from TiO₂, ZrO₂, and HfO₂, and
(c) forming a layer of a transparent conductive oxide (TCO) above the dielectric metal oxide layer (b).

8. Process according to Claim 7, further comprising a step (d) of forming a metal grid making direct contact with the transparent conductive oxide layer, this step (d) comprising at least one step of acid etching.

9. Process according to Claim 8, wherein step (d) is carried out after step (b) and before step (c) so that the metal grid makes contact both with the dielectric metal oxide barrier layer and with the TCO layer.

10. Process according to Claim 8, wherein step (d) is carried out after step (c) so that the metal grid makes contact with the TCO layer but not with the metal oxide barrier layer.
